# EUROPEAN PATENT APPLICATION

(11) **EP 4 661 061 A1**
(43) Date of publication of application: **10.12.2025**
(21) Application number: 24895354.9
(22) Date of filing: 21.03.2024
(51) Int. Cl.: H01L 21/50, H01L 21/306, H01L 21/762

(54) **BONDING METHOD AND SOI SUBSTRATE PREPARATION METHOD**

(30) Priority: 30.11.2023 CN 202311629938
(71) Applicant: Shangai Advanced Silicon Technology Co., Ltd, Shanghai 201616 (CN); Chongquing Advanced Silicon Technology Co., Ltd., Chongqing 400799 (CN)
(72) Inventor: CHEN, Meng, Shanghai 201616 (CN); ZHANG, Chenbin, Shanghai 201616 (CN); YE, Fei, Shanghai 201616 (CN); LI, Jing, Shanghai 201616 (CN); WANG, Qianxi, Shanghai 201616 (CN); LIU, Hongbing, Shanghai 201616 (CN)
(74) Representative: Metida
(86) International application number: PCT/CN2024/082949
(87) International publication number: WO 2025/112241

(57) **Abstract**

Disclosed are a bonding method and a method for fabricating an SOI substrate. The method includes: providing a first silicon substrate and a second silicon substrate; performing an activation treatment on a surface of at least one of the first silicon substrate or the second silicon substrate, such that the surface thereof adsorbs -OH groups; pre-bonding the first silicon substrate and the second silicon substrate to form a combined substrate; and heating the combined substrate upon pre-bonding, and maintaining for a predetermined period of time to anneal and dehydrate a bonding interface. The present disclosure provides a method that utilizes activation and annealing to convert van der Waals forces at a bonding interface into chemical bonds. This process strengthens the bonding interface and reduces the width of unbonded regions. When applied in the field of SOI substrate fabrication, the method provides an improved support environment for a subsequent exfoliation process.

## Description

### TECHNICAL FIELD

The present disclosure relates to the field of semiconductor manufacturing, and in particular, relates to a bonding method and a method for fabricating a silicon-on-insulator (SOI) substrate.

### BACKGROUND

In the field of semiconductors, low-temperature pre-bonding techniques are known in the art. In a conventional process for fabricating an SOI substrate, bonded wafers are subjected to high-temperature annealing, which induces exfoliation at a hydrogen-implanted plane to yield the SOI substrate. A drawback of this conventional process is that a significantly wide, unbonded, and overhanging region is often formed at a periphery of the SOI substrate upon the exfoliation. Accordingly, it is a challenge in the art to improve the bonding process to reduce the width of the unbonded region at the periphery of the SOI substrate.

### SUMMARY

Embodiments of the present disclosure are intended to provide a bonding method and a method for fabricating an SOI substrate.

In one aspect, the embodiments of the present disclosure provide a bonding method. The method includes: providing a first silicon substrate and a second silicon substrate; performing an activation treatment on a surface of at least one of the first silicon substrate or the second silicon substrate, such that the surface thereof adsorbs -OH groups; pre-bonding the first silicon substrate and the second silicon substrate to form a combined substrate; and heating the combined substrate upon pre-bonding, and maintaining for a predetermined period of time to anneal and dehydrate a bonding interface.

In some embodiments, the combined substrate is heated to a temperature of 60°C to 120°C.

In some embodiments, the predetermined period of time is 3 to 8 hours.

In some embodiments, the surfaces of both the first silicon substrate and the second silicon substrate are subjected to the activation treatment.

In some embodiments, an oxide layer is formed on the surface of the at least one of the first silicon substrate and the second silicon substrate.

In another aspect, the embodiments of the present disclosure provide a method for fabricating an SOI substrate. The method includes: providing a first silicon substrate and a second silicon substrate; performing ion implantation into the first silicon substrate to form a device layer; forming an oxide layer on a surface of at least one of the first silicon substrate or the second silicon substrate; performing an activation treatment on the surface of at least one of the first silicon substrate or the second silicon substrate, such that the surface thereof adsorbs -OH groups; pre-bonding the first silicon substrate and the second silicon substrate to form a combined substrate; and heating the combined substrate upon pre-bonding, and maintaining for a predetermined period of time to anneal and dehydrate a bonding interface.

In some embodiments, the combined substrate is heated to a temperature of 60°C to 120°C.

In some embodiments, the predetermined period of time is 3 to 8 hours.

In some embodiments, the surfaces of both the first silicon substrate and the second silicon substrate are subjected to the activation treatment.

In some embodiments, an oxide layer is formed on the surface of the at least one of the first silicon substrate and the second silicon substrate.

The present disclosure provides a method that utilizes activation and annealing to convert van der Waals forces at a bonding interface into chemical bonds. This process strengthens the bonding interface and reduces the width of unbonded regions. When applied in the field of SOI substrate fabrication, the method provides an improved support environment for a subsequent exfoliation process.

### BRIEF DESCRIPTION OF THE DRAWINGS

FIG. 1 is a schematic diagram of steps of a bonding method according to a specific embodiment of the present disclosure;
FIG. 2 is a schematic diagram illustrating a bonding method according to a specific embodiment of the present disclosure; and
FIG. 3 is a schematic diagram of steps of a method for fabricating an SOI substrate according to a specific embodiment of the present disclosure.

### DETAILED DESCRIPTION

Specific embodiments illustrating a bonding method and a method for fabricating an SOI substrate according to the present disclosure are described in detail with reference to the accompanying drawings.

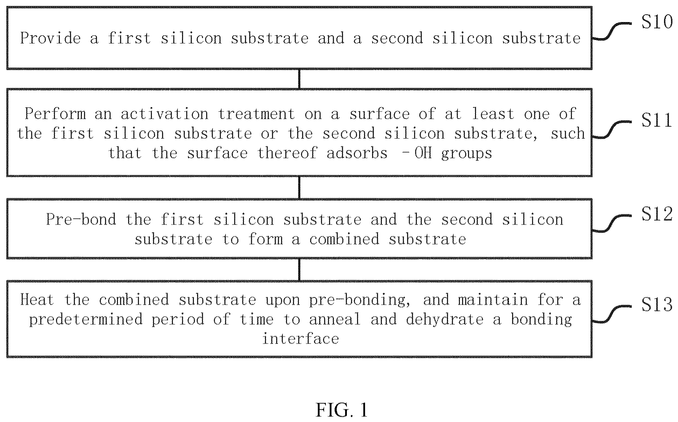

FIG. 1 is a schematic flowchart of steps of a bonding method according to a specific embodiment of the present disclosure. The method includes: S10, providing a first silicon substrate and a second silicon substrate; S11, performing an activation treatment on a surface of at least one of the first silicon substrate or the second silicon substrate, such that the surface thereof adsorbs -OH groups; S12, pre-bonding the first silicon substrate and the second silicon substrate to form a combined substrate; and S13, heating the combined substrate upon pre-bonding, and maintaining for a predetermined period of time to anneal and dehydrate a bonding interface.

Specifically, in S11, an activation treatment is performed on the surface of at least one of the first silicon substrate or the second silicon substrate, such that the surface thereof adsorbs -OH groups. In this step, the activation treatment may be performed on both the first silicon substrate and the second silicon substrate. Furthermore, an oxide layer may be formed on the surface of the at least one of the first silicon substrate and the second silicon substrate. Regardless of whether an oxide layer is present, silicon atoms are present in the surface of the at least one of the first silicon substrate and the second silicon substrate, and thus the ability of the silicon on the surfaces to adsorb -OH groups is not affected.

In S12, the first silicon substrate and the second silicon substrate are pre-bonded to form a combined substrate. The environment during bonding needs to be extremely clean and free from contaminations of particulates and metals. A bonding wave has a specific propagation time.

In S13, the combined substrate upon pre-bonding is heated, and maintained for a predetermined period of time to anneal and dehydrate a bonding interface. This step may be carried out by using a thermal chamber with constant temperature, wherein the bonded wafer is subjected to a dehydration treatment by being held at a temperature of 60 to 120°C for 3 to 8 hours. Intermolecular forces (van der Waals forces) gradually transform into chemical forces (chemical bonds), thereby enhancing the bonding strength. The reaction equation at the surface is as follows:

Si-OH + HO-Si → Si-O-Si + H₂O

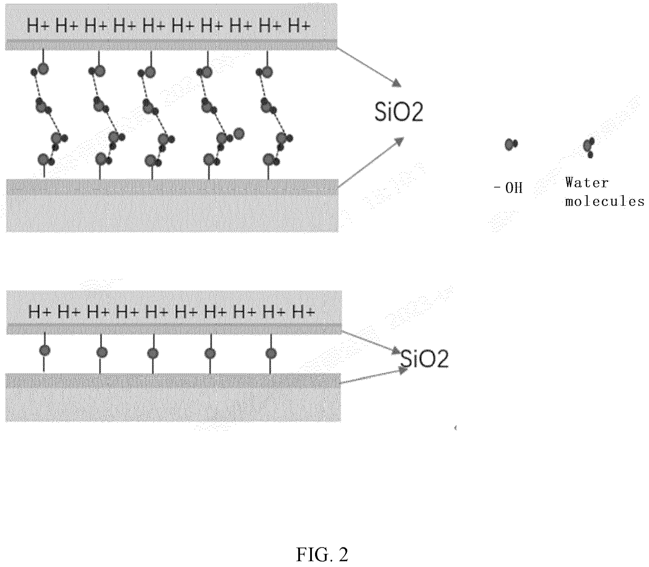

FIG. 2 is a schematic diagram illustrating the reaction at the interface.

At edge portions of the substrate upon bonding, water may be evaporated via heating, such that the bonding strength of the edge portions is enhanced and the width of an unbonded region at the edge is reduced. It has been experimentally demonstrated that the method may reduce the width of the unbonded region at the edge from 3 mm to less than 1.5 mm.

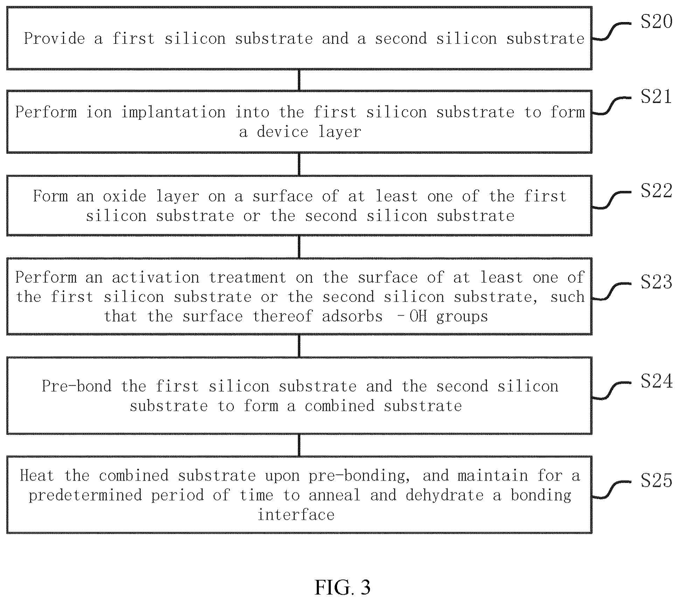

FIG. 3 is a schematic flowchart of steps of a method for fabricating an SOI substrate according to a specific embodiment of the present disclosure. The method includes: S20, providing a first silicon substrate and a second silicon substrate; S21, performing ion implantation into the first silicon substrate to form a device layer; S22, forming an oxide layer on a surface of at least one of the first silicon substrate or the second silicon substrate; S23, performing an activation treatment on the surface of at least one of the first silicon substrate or the second silicon substrate, such that the surface thereof adsorbs -OH groups; S24, pre-bonding the first silicon substrate and the second silicon substrate to form a combined substrate; and S25, heating the combined substrate upon pre-bonding, and maintaining for a predetermined period of time to anneal and dehydrate a bonding interface.

Specifically, the ion implantation in S21 may be implantation of one or a combination of H and He to form a blistering layer, thereby defining a device layer.

In S22, an oxide layer is formed on the surface of the at least one of the first silicon substrate or the second silicon substrate; The function of the oxide layer is to provide a buried oxide for the SOI substrate; therefore, the oxide layer may be formed on the surface of either the first silicon substrate or the second silicon substrate, or may be formed on both simultaneously.

In S23, an activation treatment is performed on the surface of at least one of the first silicon substrate or the second silicon substrate, such that the surface thereof adsorbs -OH groups. In this step, the activation treatment may be performed on both the first silicon substrate and the second silicon substrate. Furthermore, regardless of whether an oxide layer is present, silicon atoms are present in the surface of the at least one of the first silicon substrate and the second silicon substrate, and thus the ability of the silicon on the surfaces to adsorb -OH groups is not affected.

In S25, the combined substrate upon pre-bonding is heated, and maintained for a predetermined period of time to anneal and dehydrate a bonding interface. This step may be carried out by using a thermal chamber with constant temperature, wherein the bonded wafer is subjected to a dehydration treatment by being held at a temperature of 60 to 120°C for 3 to 8 hours. Intermolecular forces (van der Waals forces) gradually transform into chemical forces (chemical bonds), thereby enhancing the bonding strength. The reaction equation at the surface is as follows:

Si-OH + HO-Si → Si-O-Si + H₂O

FIG. 2 is a schematic diagram illustrating the reaction at the interface.

At edge portions of the substrate upon bonding, water may be evaporated via heating, such that the bonding strength of the edge portions is enhanced and the width of the unbonded region at the edge is reduced, and hence a more effective support environment is provided for subsequent exfoliation of the substrate from the blistering layer. It has been experimentally demonstrated that the method may reduce the width of the unbonded region at the edge from 3 mm to less than 1.5 mm.

Upon completion of the steps, an annealing and exfoliation step is further required, wherein the first substrate is exfoliated at the blistering layer to form the SOI substrate. Because annealing is performed, which reduces the width of the unbonded region at the edge, the exfoliation of this step may be carried out more successfully.

Described above are exemplary embodiments of the present disclosure. It should be noted that persons of ordinary skill in the art may derive other improvements or polishments without departing from the principles of the present disclosure. Such improvements and polishments shall be deemed as falling within the protection scope of the present disclosure.

## Claims

1. A bonding method, comprising:
providing a first silicon substrate and a second silicon substrate;
performing an activation treatment on a surface of at least one of the first silicon substrate or the second silicon substrate, such that the surface thereof adsorbs -OH groups;
pre-bonding the first silicon substrate and the second silicon substrate to form a combined substrate; and
heating the combined substrate upon pre-bonding, and maintaining for a predetermined period of time to anneal and dehydrate a bonding interface.

2. The method according to claim 1, wherein the combined substrate is heated to a temperature of 60°C to 120°C.

3. The method according to claim 1, wherein the predetermined period of time is 3 to 8 hours.

4. The method according to claim 1, wherein the surfaces of both the first silicon substrate and the second silicon substrate are subjected to the activation treatment.

5. The method according to claim 1, wherein an oxide layer is formed on the surface of the at least one of the first silicon substrate and the second silicon substrate.

6. A method for fabricating a silicon-on-insulator (SOI) substrate, comprising:
providing a first silicon substrate and a second silicon substrate;
performing ion implantation into the first silicon substrate to form a device layer;
forming an oxide layer on a surface of at least one of the first silicon substrate or the second silicon substrate;
performing an activation treatment on the surface of at least one of the first silicon substrate or the second silicon substrate, such that the surface thereof adsorbs -OH groups;
pre-bonding the first silicon substrate and the second silicon substrate to form a combined substrate; and
heating the combined substrate upon pre-bonding, and maintaining for a predetermined period of time to anneal and dehydrate a bonding interface.

7. The method according to claim 6, wherein the combined substrate is heated to a temperature of 60°C to 120°C.

8. The method according to claim 6, wherein the predetermined period of time is 3 to 8 hours.

9. The method according to claim 6, wherein the surfaces of both the first silicon substrate and the second silicon substrate are subjected to the activation treatment.

10. The method according to claim 6, wherein an oxide layer is formed on the surfaces of both the first silicon substrate and the second silicon substrate.
